# EUROPEAN PATENT APPLICATION

(11) **EP 1 355 429 A2**
(43) Date of publication of application: **22.10.2003**
(21) Application number: 03290845.1
(22) Date of filing: 04.04.2003
(51) Int. Cl.: H03M 13/00

(54) **ECC block encoder and decoder with reduced RAM memory requirement**

(30) Priority: 16.04.2002 DE 10216999
(71) Applicant: Thomson Licensing S.A., 92100 Boulogne-Billancourt (FR)
(72) Inventor: Kern, Alois, 78048 Villingen-Schwenningen (DE); Keesen, Heinz-Werner, 30173 Hannover (DE)
(74) Representative: Thies, Stephan

(57) **Abstract**

The present invention relates to a method and an apparatus for creating a data block (Error Correction Code Block (ECC Block)) comprising a plurality of data sectors, which data block is provided with parity information, and to a method and an apparatus for recovering data sectors from a data block provided with parity information.

It is an object of the invention to propose a method for encoding or decoding data streams, respectively, which has a reduced memory requirement and manages with two encoders 12, 14 or decoders, respectively, and to an encoding or decoding unit 10, respectively, for implementing the method according to the invention.

According to the invention, in the case of a method for creating an ECC block comprising a plurality of data sectors, the data sectors being buffer-stored in the form of a block with a plurality of rows in a memory 11,13 organized in the form of rows and columns and being provided with parity information, the object is achieved by virtue of the fact that successively received blocks of data sectors are written row by row alternately to the rows or columns, respectively, of the memory 11,13.

## Description

The present invention relates to a method and an apparatus for creating a data block (Error Correction Code Block (ECC Block)) comprising a plurality of data sectors, which data block is provided with parity information, and to a method and an apparatus for recovering data sectors from a data block provided with parity information.

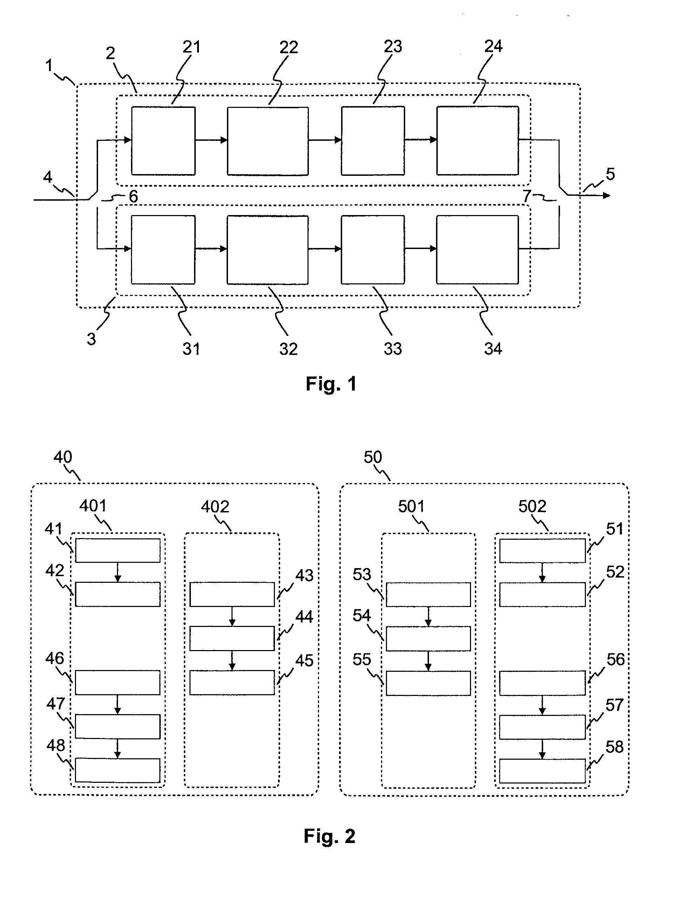

Methods of this type are used in most methods for digital data communication and data storage. Known methods for digital data communication are DVB (Digital Video Broadcasting) or DAB (Digital Audio Broadcasting), for example. In the case of the methods for digital data storage, mention may be made essentially of tape storage (e.g. DAT (Digital Audio Tape), DVC (Digital Video Cassette), DVHS (Digital Video Home System)), disc storage (e.g. hard disk, CD-R (Compact Disc Recordable), DVD+RW (Digital Versatile Disc+Read/Write)) and storage on memory cards (e.g. CompactFlash). In the case of the methods mentioned and further methods, too, data sectors for the storage or transmission, respectively, are provided with parity information in order, when reading or receiving the data, to enable errors to be corrected if read or reception errors occur. Prior to the writing or communication process, the data are provided with parity information, i.e. encoded. After the reading or reception process, respectively, the data have to be freed of the parity information, they are decoded. A known encoding unit 1 is illustrated diagrammatically in Figure 1. It has two encoding branches 2, 3, which are constructed identically. The two encoding branches 2, 3 each comprise a first memory 21, 31, a first encoder 22, 32, a second memory 23, 33 and a second encoder 24, 34, the memories 21, 23, 31, 33 being organized in the form of rows and columns. The encoders 22, 24, 32, 34 may be, by way of example, Reed-Solomon encoders (RS encoders) or XOR encoders; other types are also possible. RAM memories are usually used as memories 21, 23, 31, 33. Data sectors pass via an input 4 into the encoding unit 1, where they are forwarded via a switch 6 to the first encoding branch 2 or the second encoding branch 3. In the two encoding branches 2, 3, the data sectors are in each case provided with parity information by the first encoder 22, 32 and by the second encoder 24, 34 and output via a second switch 7 to an output 5. A corresponding decoder is constructed identically, in principle, corresponding decoders (e.g. Reed-Solomon (RS) decoders, XOR decoders) merely being used instead of the encoders 22, 32, 24, 34.

The basic method of operation of the encoding unit 1 according to the prior art will be explained below with reference to Figure 1 and Figure 2. In this case, the description is based on an encoding unit for DVD-RAM or DVD+RW, respectively.

The encoding operation can be divided into two recurring phases 40, 50. The phases are identical, in principle, the roles of the two encoding branches 2, 3 merely being interchanged. In the figure, the method steps for the two phases 40, 50 are divided into those method steps 401, 501 which proceed in the first encoding branch 2, and those method steps 402, 502 which proceed in the second encoding branch 3. The arrangement of the different method steps one beside the other and one below the other does not necessarily represent a temporal sequence, unless a temporal sequence is explicitly prescribed by the arrows depicted.
Firstly, the first phase 40 will be explained. In a step 41, 16 data sectors each of 2064 bytes pass into the first encoding branch 2. In the next step 42, these are written to the first memory 21 of the first encoding branch in the form of 192 rows each of 172 bytes. Meanwhile, in the second encoding branch 3, in a step 43, data already stored in the first memory 31 in the form of 192 rows each of 172 bytes are read column by column from said first memory. The data read are forwarded to the first encoder 32 and provided with in each case 16 bytes of outer parity information per column by said encoder. In a subsequent step 45, the 172 columns each of 208 bytes thus obtained are written to the columns of the second memory 33 of the second encoding branch 3. Consequently, the second memory 33 holds 208 rows each of 172 bytes, the first 192 rows forming a data area and the remaining 16 rows forming a parity area. Steps 43-45 are omitted at the beginning of the encoding operation, when there are as yet no data present in the first memory 31 of the second encoding branch 3.
In step 46, 208 rows each of 172 bytes are read from the second memory 23 of the first encoding branch 2 and forwarded to the second encoder 24, which provides them with in each case 10 bytes of inner parity information per row in a subsequent step 47. In this case, the block of data sectors may additionally be protected from errors by interleaving of the rows. Twelve rows from the data area are then in each case followed by one row from the parity area. Finally, in a step 48, the now completely encoded 16 data sectors are output in the form of 208 rows each of 182 bytes via the switch 7 and the output 5 and can be recorded or transmitted. Steps 46-48 are also omitted at the beginning of the encoding operation since there are as yet no data present in the second memory 23 of the first encoding branch 2.
After the first phase 40 has ended, the role of first encoding branch 2 and second encoding branch 3 are interchanged in the second phase 50. In step 51, the next 16 data sectors pass via the input 4 and the switch 6 into the second encoding branch 3 and are written to the first memory 31 of the second encoding branch 3 in the form of 192 rows each of 172 bytes. The 192 rows each of 172 bytes that were written to the first memory 21 of the first encoding branch 2 in step 42 in the first phase 40 are now read, in step 53, in the form of 172 columns each of 192 bytes, forwarded to the first encoder 22, provided with 16 bytes of outer parity information per column by said encoder in step 54 and, in step 55, written to the second memory 23 of the first encoding branch 2 in the form of 172 columns each of 208 bytes. The 208 rows each of 172 bytes that are present in the second memory 33 of the second encoding branch 3 from step 45 of the first phase 40 are correspondingly read in step 56, forwarded to the second encoder 34, provided with in each case 10 bytes of inner parity information per row by said encoder in step 57, if appropriate interleaved and, in a step 58, output via the switch 7 and the output 5.
An incoming data stream at the input 4 of the encoding unit 1 is continuously encoded through the progressive repetition of the two phases 40, 50.

A decoding unit according to the prior art operates analogously to the above description. In this case, those steps in which the data are provided with parity information by the encoders 22, 24, 32, 34 during the encoding process are replaced by corresponding steps in which the data provided with parity information are freed of the parity information items by decoders. Moreover, the data are freed firstly of the inner parity information and only afterwards of the outer parity information; the order is thus opposite to the order during the encoding process, for which reason the roles of input 4 and output 5 are also interchanged. The number and length of the rows and columns to be written or to be read, respectively, changes correspondingly. Strictly speaking, freeing the data of the parity information is a complex operation of error correction. Either all errors can already be corrected with the inner parity information by the first decoder or the entire row is marked as uncorrectable. It is only by the second decoder that the remaining marked bytes are then corrected by means of the outer parity information. However, in the case of large defects (e.g. holes, scratches, etc.) on the storage medium from which the data are read, there is a certain probability of the second error correction also going wrong, so that residual errors remain.

The known encoding or decoding unit, respectively, has the disadvantage that the continuous encoding or decoding, respectively, of a data stream necessitates a total of four memories and four encoders or decoders, respectively, two of which in each case fulfil the same task. Since these individual components are comparatively expensive, the use of an encoding or decoding unit, respectively, according to the prior art gives rise to relatively high costs.

Therefore, it is an object of the invention to propose a method for encoding or decoding data streams, respectively, which has a reduced memory requirement and manages with two encoders or decoders, respectively, and an encoding or decoding unit, respectively, for implementing the method according to the invention. It is a further object of the invention to propose an apparatus for reading from and/or writing to storage media and a method for communicating or for receiving digital data streams which uses a method according to the invention or an encoding or decoding unit, respectively, according to the invention for encoding or decoding data streams, respectively.

According to the invention, in the case of a method for creating an ECC block comprising a plurality of data sectors, the data sectors being buffer-stored in the form of a block with a plurality of rows and columns in a memory organized in the form of rows and columns and being provided with parity information, the object is achieved by virtue of the fact that successively received blocks of data sectors are written row by row alternately to the rows or columns, respectively, of the memory. This has the advantage that a row or column, respectively, situated in the memory can be overwritten by the next received row directly after reading, without data which are still required for the creation of parity information being erased in the process.

The memory advantageously has a first RAM memory and a second RAM memory. In this way, the parity information can be created in two steps, first for the rows and then for the columns of the block of data sectors, so that it is possible to use customary encoders for encoding. The two RAM memories need not necessarily be physically separate; subareas of a superordinate RAM memory may also be involved.

According to the invention, a first block of data sectors which is situated in the second RAM memory and is provided with a first parity information item and has a data area and a parity area is read, provided with a second parity information item and output, and in that a second block of data sectors which is situated in the first RAM memory is read, provided with the first parity information item and stored in the second RAM memory. This ensures that the data situated in the second RAM memory are replaced by new data only when they have been completely encoded and output.

According to the invention, in the case of a method for recovering a plurality of data sectors from an ECC block of data sectors which is provided with parity information, the ECC block being buffer-stored in a memory organized in the form of rows and columns, the object is achieved by virtue of the fact that successively received ECC blocks of data sectors are written row by row alternately to the rows or columns, respectively, of the memory. This has the advantage that a row or column, respectively, of the memory can be overwritten by the next received row of the next ECC block of data sectors without data which are still required for decoding being erased in the process.

The memory advantageously has a first RAM memory and a second RAM memory. This has the advantage that the parity information can be removed in two steps first for the rows and then for the columns of the block of data sectors, so that it is possible to use customary decoders for decoding. The two RAM memories need not necessarily be physically separate; subareas of a superordinate RAM memory may also be involved.

According to the invention, a first ECC block of data sectors which is situated in the first RAM memory and is provided with a first parity information item is read, freed of the first parity information item and stored in the second RAM memory, and in that a second subsequently received ECC block of data sectors which is provided with a first and a second parity information item is freed of the second parity information item and stored in the first RAM memory. This ensures that the data situated in the first RAM memory are replaced by new data only when they have been completely decoded and stored in the second RAM memory.

According to the invention, the first (ECC) block of data sectors is read row by row from the second RAM memory if it was written column by column to the second RAM memory, and column by column if it was written row by row to the second RAM memory, and in that the second (ECC) block of data sectors is read row by row from the first RAM memory and is written row by row to the second RAM memory if it was written row by row to the columns of the first RAM memory, and is read column by column and written column by column to the second RAM memory if it was written row by row to the rows of the first RAM memory. This ensures that at no time during the encoding or decoding are data that are still required overwritten by other data. The formulation "(ECC) block of data sectors" expresses here and below that the characterizing features of the method apply equally to a block of data sectors and to an ECC block of data sectors.

According to the invention, a further subsequently received (ECC) block of data sectors is written row by row to the rows or columns, respectively, of the first RAM memory if the second (ECC) block of data sectors was read row by row or column by column, respectively, from the first RAM memory. What is achieved in this way is that no data that are still required are overwritten by a subsequently received (ECC) block of data sectors either.

In an advantageous manner, in each case directly after the reading of a row or column, respectively, from the second RAM memory, the corresponding row or column, respectively, is read from the first RAM memory and written to the currently read row or column, respectively, of the second RAM memory. This has the advantage that data can already be written to the second RAM memory at a point in time at which not all the data present in the second RAM memory have yet been processed. It is not necessary, therefore, to wait for the second RAM memory to be read in its entirety.

In accordance with a further aspect of the invention, in each case after the process of reading, provision with parity information and outputting of a fixed number of rows or columns, respectively, from the data area in the second RAM memory, a row or column, respectively, is read from the parity area in the second RAM memory, provided with a second parity information item and output, the read row or column, respectively, not being overwritten immediately. This enables an interleaving of the ECC block of data sectors, thereby increasing the error protection.

Furthermore, in an advantageous manner, in each case directly after the reading of a row or column, respectively, from the first RAM memory, the corresponding row of the further subsequently received (ECC) block of data sectors is written to the currently read row or column, respectively. The advantage here lies in the fact that data can already be written to the first RAM memory at a point in time at which not all the data present in the first RAM memory have yet been processed. Once again there is no need first to wait for the first RAM memory to be read in its entirety.

According to the invention, after the reading of all the rows or columns, respectively, written to in the first RAM memory, remaining rows of the further subsequently received (ECC) block of data sectors are written to the further rows or columns, respectively, of the first RAM memory, and in that after the reading of all the rows or columns, respectively, of the second RAM memory which, after reading, were overwritten by corresponding rows or columns, respectively, read from the first RAM memory, unread rows or columns, respectively, of the second RAM memory that have remained are read and output. What is achieved in this way is that the (ECC) blocks of data sectors are completely encoded or decoded, respectively, even if they have a different number of rows and columns.

In an advantageous manner, the blocks of data sectors each comprise 16 data sectors, as occurs for example when encoding or decoding data streams, respectively, for DVD+RW or DVD-RAM.

According to the invention, the blocks of data sectors each comprise 192 rows each of 172 bytes. In this way, data streams can be encoded or decoded, respectively, in accordance with the DVD standard.

According to the invention, the ECC blocks of data sectors each comprise 208 rows each of 182 bytes. This also corresponds to the DVD standard.

According to the invention, the first parity information item comprises 16 bytes and the second parity information item comprises 10 bytes, as corresponds to the DVD standard.

An encoding unit for creating an ECC block comprising a plurality of data sectors, the data sectors being buffer-stored in a memory and provided with parity information items, advantageously uses a method according to the invention for encoding the data sectors. Such an encoding unit has the advantage that, in comparison with the prior art, it has a memory requirement reduced to half and needs only two instead of four encoders.

According to the invention, a decoding unit for recovering a plurality of data sectors from an ECC block of data sectors which is provided with parity information, the ECC block being buffer-stored in a memory, uses a method according to the invention for decoding the data sectors. Such a decoding unit has the advantage that, in comparison with the prior art, it has a memory requirement reduced to half and needs only two instead of four decoders.

According to the invention, an apparatus for reading from and/or writing to storage media uses a method or an encoding unit according to the invention for encoding a data stream or a method for a decoding unit according to the invention for decoding a data stream. Such an apparatus can be produced at lower cost since a reduced number of components are needed for encoding or decoding the data stream, respectively.

In accordance with a further aspect of the invention, a method for communicating a digital data stream uses a method according to the invention or an encoding unit according to the invention for encoding the data stream to be communicated. Here, too, the advantage lies in the reduced costs which are necessary for encoding the data stream to be communicated.

Correspondingly, a method for receiving a digital data stream uses a method according to the invention or a decoding unit according to the invention for decoding the received data stream. Here, too, the advantage lies in the reduced costs which are necessary for decoding the received data stream.

The methods according to the invention are advantageously carried out by a computer program. This makes it possible to use the methods in program-controlled apparatuses which already have memory modules for other purposes, without having to provide special memories for the encoding or decoding of data streams.

It goes without saying that combinations of advantageous features likewise lie within the scope of validity of the invention.

In order to provide a better understanding, the invention will be explained below with reference to Figures 1 to 5, in which:
Figure 1 shows an encoding unit according to the prior art,
Figure 2 shows a method for encoding a data stream with an encoding unit according to the prior art,
Figure 3 shows an encoding unit according to the invention,
Figure 4 shows a decoding unit according to the invention,
Figure 5 shows a method for encoding a data stream with an encoding unit according to the invention.

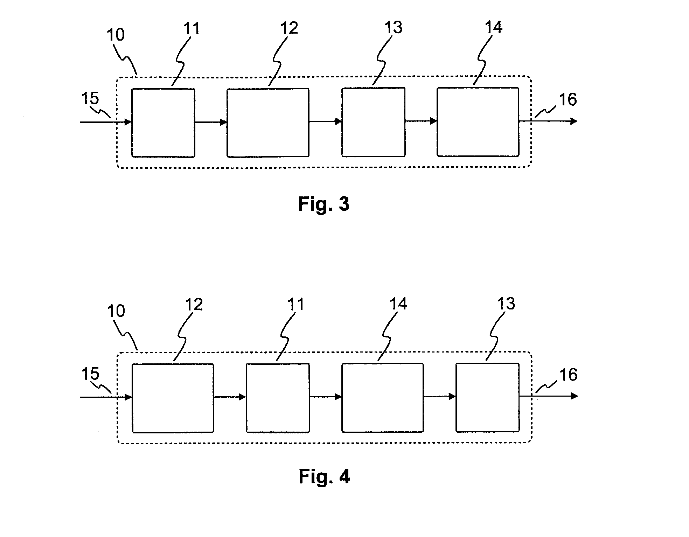

Figure 3 diagrammatically shows an encoding unit 10 according to the invention. In contrast to the prior art, the encoding unit 10 has, besides an input 15 and an output 16, merely a first RAM memory 11 and a second RAM memory 13 and also a first encoder 12 and a second encoder 14. Data received via the input 15 are stored in the first RAM memory 11, read from there, provided with a first parity information item by the first encoder 12 and stored in the second RAM memory 13. The data stored in the second RAM memory 13 are likewise read out, provided with a second parity information item by the second encoder 14 and output via the output 16 of the encoding unit.

Figure 4 diagrammatically shows a decoding unit 10 according to the invention. In comparison with the encoding unit 10 shown in Figure 3, the differences lie merely in the reversed arrangement of the RAM memories 11, 13 and the decoders 12, 14. An ECC block which is received via the input 15 and is provided with a first and a second parity information item is freed of the second parity information item by the first decoder 12 and stored in the first RAM memory 11. The data stored in the first RAM memory 11 are read out, freed of the first parity information item by the second decoder 14 and stored in the second RAM memory 13, from where they are in turn read out and output via the output 16.

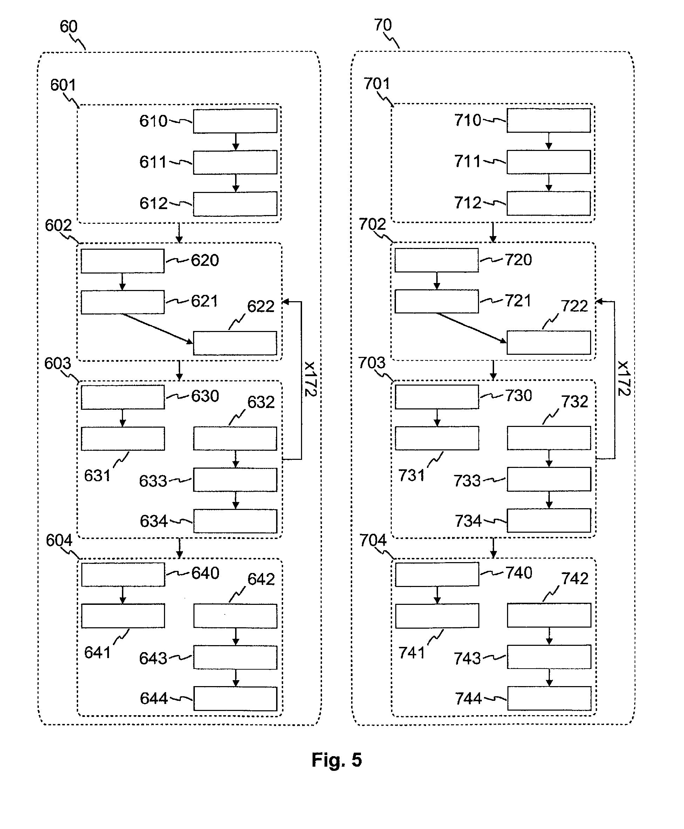

Figure 5 diagrammatically illustrates a method according to the invention for encoding a data stream with the encoding unit shown in Figure 3. In the example, the intention is to encode a data stream for DVD+RW or DVD-RAM, respectively, i.e. in each case 16 data sectors are provided, in the form of a block of 192 rows each of 172 bytes, with 16 bytes of outer parity information per column and 10 bytes of inner parity information per row and are output in the form of an ECC block with 208 rows each of 182 bytes. Furthermore, it is assumed that data are already present in the first RAM memory 11 and in the second RAM memory 13. If this is not the case, the method begins firstly with step 630 until a first cycle has been run through and the assumption is fulfilled.
The method according to the invention can be subdivided into two phases 60, 70, a complete block of data sectors being received and a complete ECC block of data sectors being output both in the first phase 60 and in the second phase 70. Therefore, the two phases 60, 70 are repeated continuously in order to encode a data stream. The two phases can be subdivided into in each case four sub-phases 601, 602, 603, 604 and 701, 702, 703, 704, respectively. In Figure 4, both in the first phase 60 and in the second phase 70, all the sub-phases 601-604 and 701-704, respectively, are graphically subdivided into a left-hand and a right-hand half. Method steps in the left-hand half relate in each case to the input 15, the first RAM memory 11 and the first encoder 12, and method steps in the right-hand half relate to the second RAM memory 13, the second encoder 14 and the output 16.

At the beginning of the first phase 60, the second RAM memory 13 holds data in the form of 208 rows each of 172 bytes, the first 192 rows forming a data area and the remaining 16 rows forming a parity area. In the first sub-phase 601, in step 610, the first row of 172 bytes is read from the second RAM memory 13. In step 611, this row is provided with 10 bytes of inner parity information by the second encoder 14 and, in step 612, is output as a row of 182 bytes via the output 16. The first row of the second RAM memory 13 can thus be overwritten by new data. In the second sub-phase 602, in step 620, a row of 192 bytes is read from the first RAM memory 11. In step 621, this row is provided with 16 bytes of outer parity information by the first encoder 12 and, in step 622, is written to the freed row of the second RAM memory 13. The third sub-phase 603 begins, in which firstly, in step 630, a row of 172 bytes of the next block of data sectors is received via the input 15. In step 631, this row is written to the first row of the first RAM memory 11. In step 632, the next row of 172 bytes is read from the second RAM memory 13 and forwarded to the second encoder 14. In step 633, it is provided with 10 bytes of inner parity information by said encoder and, in step 634, is output via the output 16. The second sub-phase 602 and the third sub-phase 603 are run through 172 times in total, in which case, in the n-th iteration, in step 620, the n-th row is in each case read from the first RAM memory 11 and, after being provided with outer parity information, in step 622, is written to the n-th row of the second RAM memory 13. In addition, in step 630, the n-th row of the next block of data sectors is in each case received and then, in step 631, is written to the n-th row of the first RAM memory 11, in which case, in step 632, the (n+1)-th row of the second RAM memory 13 is read and, in step 634, is output as (n+1)-th row of the ECC block. Once the second and third sub-phases 602, 603 have been run through 172 times in total, the fourth sub-phase 604 begins. In step 640, the remaining 20 rows each of 172 bytes of the next block of data sectors are received via the input 15 and, in step 641, are written to the corresponding 20 rows of the first RAM memory 11. Furthermore, in step 642, the remaining 35 rows each of 172 bytes that have not yet been read are read from the second RAM memory 13, and, in step 643, are provided with in each case 10 bytes of inner parity information per row by the second encoder 14 and, in step 644, are output in the form of 35 rows each of 182 bytes via the output 16. Consequently, after the fourth sub-phase 604 has ended, overall a complete block of data sectors has been written to the first RAM memory 11 and a complete ECC block of data sectors has been output via the output 16. Moreover, a block of data sectors present in the first RAM memory 11 has been provided with a first parity information and written to the second RAM memory 13. Consequently, the same preconditions prevail before the beginning of the second phase 70 as at the beginning of the first phase 60, although the roles of rows and columns are interchanged in the first and second RAM memories 11, 13.

The second phase 70 proceeds completely analogously to the first phase 60. At the beginning of the second phase 70, the second RAM memory 13 holds data in the form of 208 columns each of 172 bytes, the first 192 columns forming a data area and the remaining 16 columns forming a parity area. In the first sub-phase 701, in step 210, the first column of 172 bytes is read from the second RAM memory 13. In step 711, this column is provided with 10 bytes of inner parity information by the second encoder 14 and, in step 712, is output as a row of 182 bytes via the output 16. The first column of the second RAM memory 13 can thus be overwritten by new data. In the second sub-phase 702, in step 720, a column of 192 bytes is read from the first RAM memory 11. In step 721, this column is provided with 16 bytes of outer parity information by the first encoder 12 and, in step 722, is written to the freed column of the second RAM memory 13. The third sub-phase 703 begins, in which firstly, in step 730, a row of 172 bytes of the next block of data sectors is received via the input 15. In step 731, this row is written to the first column of the first RAM memory 11. In step 732, the next column of 172 bytes is read from the second RAM memory 13 and forwarded to the second encoder 14. In step 733, it is provided with 10 bytes of inner parity information by said encoder and, in step 734, is output via the output 16. The second sub-phase 702 and the third sub-phase 703 are run through 172 times in total, in which case, in the n-th iteration, in step 720, the n-th column is in each case read from the first RAM memory 11 and, after being provided with outer parity information, in step 722, is written to the n-th column of the second RAM memory 13, and, in step 730, the n-th row of the next block of data sectors is in each case received and, in step 731, is written to the n-th column of the first RAM memory 11, and, in step 732, the (n+1)-th column of the second RAM memory 13 is read and, in step 734, is output as (n+1)-th row of the ECC block. Once the second and third sub-phases 702, 703 have been run through 172 times in total, the fourth sub-phase 704 begins. In step 740, the remaining 20 rows each of 172 bytes of the next block of data sectors are received via the input 15 and, in step 741, are written to the corresponding 20 columns of the first RAM memory 11. Furthermore, in step 742, the remaining 35 columns each of 172 bytes that have not yet been read are read from the second RAM memory 13, and, in step 743, are provided with 10 bytes of inner parity information per column by the second encoder 14 and, in step 744, are output in the form of 35 rows each of 182 bytes via the output 16. Consequently, after the fourth sub-phase 704 has ended, a complete block of data sectors has been written to the first RAM memory and a complete ECC block of data sectors has been output via the output 16. Moreover, a block of data sectors present in the first RAM memory 11 has been provided with a first parity information and written to the second RAM memory 13.
A continuous encoding of an incoming data stream at the input 15 is achieved by the progressive repetition of the two phases 60, 70.

If, besides the addition of parity information, the block of data sectors that is to be encoded is also intended to have an interleaving, the above sequence has to be modified somewhat. After 12 rows or columns, respectively, have in each case been read from the second RAM memory 13, provided with outer parity information and output, a row or column, respectively, is additionally read from the parity area, provided with parity information and output. This row or column, respectively, is not overwritten again immediately, rather the mechanism of reading and writing stops for a moment. Accordingly, in steps 642 and 742, only 21 remaining rows or columns, respectively, are processed, rather than 35.

A decoding unit according to the invention operates analogously to the above description, but in the reverse order, so that the data are in each case firstly decoded and only then stored. In this case, those steps in which the data are provided with parity information by the encoders 12, 14 during the encoding process are replaced by corresponding steps in which the data provided with parity information are freed of the parity information items by decoders. Moreover, the data are freed firstly of the inner parity information and only afterwards of the outer parity information, in other words the order is opposite to the order during the encoding process. The same explanation that has already been given with respect to the prior art applies to freeing the data of the parity information. Strictly speaking, a complex operation of error correction is involved.

## Claims

1. Method for creating an ECC block comprising a plurality of data sectors, the data sectors being buffer-stored in the form of a block with a plurality of rows in a memory (11, 13) organized in the form of rows and columns and being provided with parity information, **characterized in that** successively received blocks of data sectors are written row by row alternately to the rows or columns, respectively, of the memory (11, 13).

2. Method according to Claim 1, **characterized in that** the memory (11, 13) has a first RAM memory (11) and a second RAM memory (13).

3. Method according to Claim 2, **characterized in that** a first block of data sectors which is situated in the second RAM memory (13) and is provided with a first parity information item and has a data area and a parity area is read (610, 632, 642, 710, 732, 742), provided (611, 633, 643, 711, 733, 743) with a second parity information item and output (612, 634, 644, 712, 734, 744), and **in that** a second block of data sectors which is situated in the first RAM memory (11) is read (620, 720), provided (621, 721) with the first parity information item and stored (622, 722) in the second RAM memory (13).

4. Method for recovering a plurality of data sectors from an ECC block of data sectors which is provided with parity information, the ECC block being buffer-stored in a memory (11, 13) organized in the form of rows and columns, **characterized in that** successively received blocks of data sectors are written row by row alternately to the rows or columns, respectively, of the memory (11, 13).

5. Method according to Claim 4, **characterized in that** the memory (11, 13) has a first RAM memory (11) and a second RAM memory (13).

6. Method according to Claim 5, **characterized in that** a first ECC block of data sectors which is situated in the first RAM memory (11) and is provided with a first parity information item is read, freed of the first parity information item and stored in the second RAM memory (13), and **in that** a second subsequently received ECC block of data sectors which is provided with a first and a second parity information item is freed of the second parity information item and stored in the first RAM memory (11).

7. Method according to Claim 3 or 6, **characterized in that** the first (ECC) block of data sectors is read row by row from the second RAM memory (13) if it was written column by column to the second RAM memory, and column by column if it was written row by row to the second RAM memory, and **in that** the second (ECC) block of data sectors is read row by row from the first RAM memory (11) and is written row by row to the second RAM memory (13) if it was written row by row to the columns of the first RAM memory (11), and is read column by column and written column by column to the second RAM memory (13) if it was written row by row to the rows of the first RAM memory (11).

8. Method according to Claim 7, **characterized in that** a further subsequently received (ECC) block of data sectors is written row by row to the rows or columns, respectively, of the first RAM memory (11) if the second (ECC) block of data sectors was read row by row or column by column, respectively, from the first RAM memory (11).

9. Method according to Claim 8, **characterized in that** in each case directly after the reading of a row or column, respectively, from the second RAM memory (13), the corresponding row or column, respectively, is read from the first RAM memory (11) and written to the currently read row or column, respectively, of the second RAM memory (13).

10. Method according to Claim 9, **characterized in that** in each case after the process of reading, provision with parity information and outputting of a fixed number of rows or columns, respectively, from the data area in the second RAM memory (13), a row or column, respectively, is read from the parity area in the second RAM memory (13), provided with a second parity information item and output, the read row or column, respectively, not being overwritten immediately.

11. Method according to Claim 9 or 10, **characterized in that** in each case directly after the reading of a row or column, respectively, from the first RAM memory (11), the corresponding row of the further subsequently received (ECC) block of data sectors is written to the currently read row or column, respectively.

12. Method according to Claim 11, **characterized in that** after the reading of all the rows or columns, respectively, written to in the first RAM memory (11), remaining rows of the further subsequently received (ECC) block of data sectors are written to the rows or columns, respectively, of the first RAM memory (11), and **in that** after the reading of all the rows or columns, respectively, of the second RAM memory (13) to which corresponding rows or columns, respectively, read from the first RAM memory (11) have been written anew, unread rows or columns, respectively, of the second RAM memory (13) that have remained are read and output.

13. Method according to one of the preceding claims, **characterized in that** the blocks of data sectors each comprise 16 data sectors.

14. Method according to one of Claims 1-3 or 7-13, **characterized in that** the blocks of data sectors each comprise 192 rows each of 172 bytes.

15. Method according to one of Claims 4-13, **characterized in that** the ECC blocks of data sectors each comprise 208 rows each of 182 bytes.

16. Method according to one of the preceding claims, **characterized in that** the first parity information item comprises 16 bytes and the second parity information item comprises 10 bytes.

17. Encoding unit (10) for creating an ECC block comprising a plurality of data sectors, the data sectors being buffer-stored in the form of a block in a memory (11, 13) and being provided with parity information, **characterized in that** it uses a method according to one of Claims 1-3 or 7-13 for the creation of the ECC block.

18. Decoding unit for recovering a plurality of data sectors from an ECC block provided with parity information, the ECC block being buffer-stored in a memory (11, 13), **characterized in that** it uses a method according to one of Claims 4-13 for the recovery of the data sectors.

19. Apparatus for reading from and/or writing to storage media, **characterized in that** it uses a method according to one of Claims 1-3 or 7-13 or an encoding unit (10) according to Claim 17 for encoding a data stream or a method according to one of Claims 4-13 or a decoding unit according to Claim 18 for decoding a data stream.

20. Method for communicating a digital data stream, **characterized in that** it uses a method according to one of Claims 1-3 or 7-13 or an encoding unit (10) according to Claim 17 for encoding the data stream to be communicated.

21. Method for receiving a digital data stream, **characterized in that** it uses a method according to one of Claims 4-13 or a decoding unit according to Claim 18 for decoding the received data stream.

22. Computer program product for carrying out a method according to one of Claims 1-13, 20 or 21.
